# FASCICULE DE BREVET EUROPEEN

(11) **EP 1 626 442 B1**
(45) Date de publication et mention de la délivrance du brevet: **12.01.2011**
(21) Numéro de dépôt: 05107383.1
(22) Date de dépôt: 11.08.2005
(51) Int. Cl.: H01L 27/146, H01L 31/0232

(54) **Capteur d'image**
Bildsensor
Image sensor

(30) Priorité: 13.08.2004 FR 0451847
(43) Date de publication de la demande: 15.02.2006
(73) Titulaire: ST MICROELECTRONICS S.A., 92120 Montrouge (FR)
(72) Inventeur: VAILLANT, Jérôme, 73000, CHAMBERY (FR)
(74) Mandataire: de Beaumont, Michel

(56) Documents cités:
- WO-A-2004/030101
- US-A1- 2003 168 679
- US-B1- 6 605 850
- PATENT ABSTRACTS OF JAPAN vol. 1999, no. 05, 31 mai 1999 (1999-05-31) -& JP 11 040787 A (SONY CORP), 12 février 1999 (1999-02-12)
- PATENT ABSTRACTS OF JAPAN vol. 016, no. 108 (E-1179), 17 mars 1992 (1992-03-17) -& JP 03 283572 A (SONY CORP), 13 décembre 1991 (1991-12-13)

## Description

### Domaine de l'invention

La présente invention concerne un capteur d'image comprenant une matrice de cellules photosensibles disposées en lignes et en colonnes et réalisées dans une technologie de type CMOS.

### Exposé de l'art antérieur

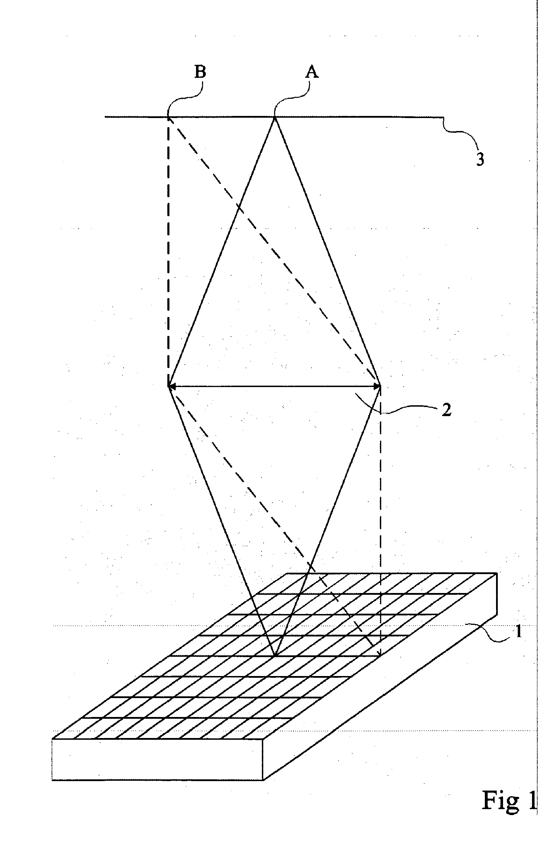

La figure 1 représente schématiquement un capteur d'image constitué d'une matrice de pixels 1 recevant par un objectif 2, l'image d'un plan objet éloigné 3. L'image d'un point A situé au milieu du plan objet va se former sensiblement au milieu de la matrice 1. L'image d'un point B situé au bord du plan objet va se former au bord de la matrice 3.

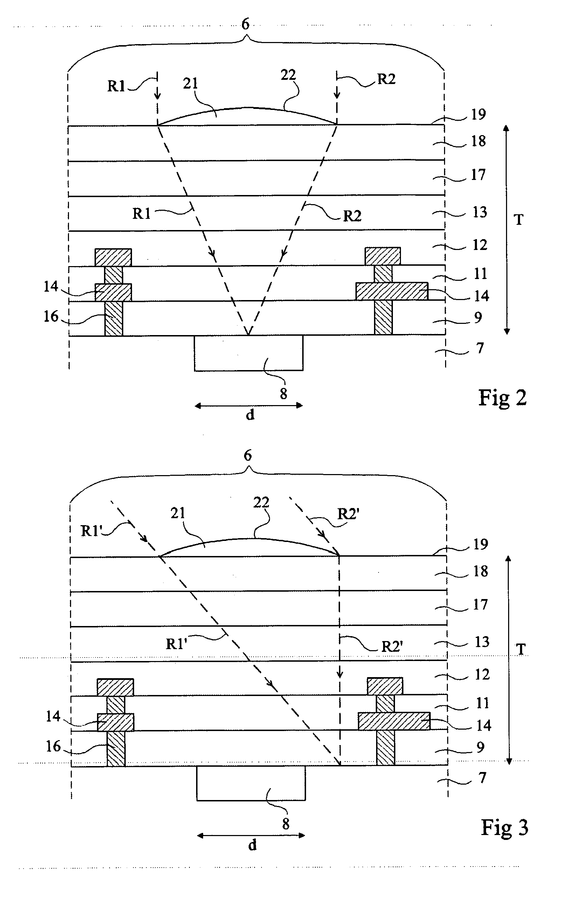

La figure 2 est une vue en coupe d'une cellule photosensible 6 sensiblement centrale d'un capteur d'image formée sur un substrat 7 par exemple du silicium. La cellule photosensible 6 est associée à une portion de la surface du substrat 7 qui, vue de dessus, a généralement la forme d'un carré ou d'un rectangle. La cellule photosensible 6 comprend une zone active photosensible 8 correspondant généralement à une photodiode adaptée à stocker une quantité de charges électriques en fonction de l'intensité lumineuse reçue. Le substrat 7 est recouvert d'un empilement de couches d'isolement transparentes 9, 11, 12, 13 qui peuvent être, à titre d'exemple, alternativement de l'oxyde de silicium et du nitrure de silicium. Des pistes conductrices 14, formées entre des couches isolantes adjacentes et des vias conducteurs 16, formés entre deux pistes conductrices, permettent notamment d'adresser la zone photosensible 8 et de recueillir des signaux électriques fournis par la zone photosensible 8. Les pistes conductrices 14 et les vias conducteurs 16 sont généralement métalliques. A titre d'exemple, on peut citer l'aluminium, le tungstène, le cuivre et des alliages métalliques. Ces matériaux sont opaques et éventuellement réfléchissants. Dans un capteur couleur, un élément de filtre de couleur 17, par exemple un filtre organique, est disposé sur l'empilement des couches d'isolement 9, 11, 12, 13 au niveau de la cellule photosensible 6. Les éléments de filtre de couleur 17 sont généralement recouverts d'une couche d'égalisation 18 planarisée qui définit une face d'exposition 19 exposée à la lumière.

Le maximum de lumière envoyée par l'objectif 2 (figure 1) sur la partie de la face d'exposition 19 associée à la cellule photosensible 1 doit être dirigé vers la zone active photosensible 8. Pour ce faire, une microlentille 21 est disposée sur la couche d'égalisation 18, en vis-à-vis de la zone photosensible 8 pour focaliser les rayons lumineux vers la zone photosensible 8. Les parcours de deux rayons lumineux R1, R2 sont schématiquement représentés à titre d'exemple pour la cellule photosensible 6. Les pistes conductrices 14 et les vias conducteurs 16 sont disposés de façon à ne pas gêner le passage des rayons lumineux. La microlentille 21 est par exemple obtenue en recouvrant la couche d'égalisation 18 d'une résine. La résine est gravée pour délimiter des blocs de résine distincts, chaque bloc de résine étant formé sensiblement en vis-à-vis d'une zone photosensible 8. Les blocs de résine sont ensuite chauffés. Chaque bloc de résine tend alors à se déformer par fluage pour obtenir une surface extérieure convexe 22. A titre d'exemple, pour une cellule photosensible 6 de 4 µm de côté et pour une distance de l'ordre de 8 à 10 µm entre une microlentille 21 et la zone photosensible 8 associée, l'épaisseur maximale de la microlentille 21 est d'environ 0,5 µm.

La zone photosensible 8 ne couvre qu'une partie de la surface du substrat 7 associée à la cellule photosensible 6. En effet, une partie de la surface est réservée à des dispositifs d'adressage et de lecture de la zone photosensible 8. Par souci de clarté, ces dispositifs n'ont pas été représentés sur la figure 2.

La figure 3 est une vue en coupe d'une cellule photosensible 6 d'un capteur d'image située au bord de la matrice de pixels. On a représenté à titre d'exemple deux rayons R1', R2'. On observe que la focalisation des rayons R1' et R2' se fait à côté de la zone photosensible 8. Ainsi, au moins une partie de la tache lumineuse fournie par la microlentille 21 ne tombe pas sur la zone photosensible 8 et les bords d'image paraîtront, pour un même éclairement, plus sombres que le centre de l'image. Il en résulte une perte de sensibilité périphérique due au décalage de l'image projetée sur les parties périphériques de la matrice de cellules photosensibles.

On cherche constamment à réduire les dimensions des capteurs d'image afin de pouvoir en intégrer un nombre toujours croissant sur une même surface d'un substrat. Il en résulte, pour la cellule photosensible 6, la réduction de la dimension latérale d de la zone photosensible 8. Par contre, la distance T entre la microlentille 21 et la zone photosensible 8 ne varie généralement pas de manière significative. Le rapport entre la distance T et la dimension latérale d tend donc à augmenter. La microlentille 21 doit donc être moins convergente pour permettre une focalisation sur la zone photosensible 8. La microlentille 21 doit donc être plus fine, ce qui implique que la couche de résine déposée sur la couche d'égalisation 18 doit être plus fine. Lors de l'étape de fluage des blocs de résine gravés dans la couche de résine, il devient en pratique difficile d'obtenir une microlentille avec une forme lui permettant de faire converger correctement les rayons lumineux. En outre, l'augmentation de ce rapport a tendance à augmenter la taille de la tache lumineuse au niveau de la zone photosensible qui peut alors devenir plus large que la zone photosensible. Cela entraîne une perte de l'intensité lumineuse disponible. Une troisième limitation du procédé de fabrication actuel résulte de la présence des pistes conductrices 14 et des vias conducteurs 16 qui peuvent être des obstacles et gêner le passage des rayons lumineux.

Le document US 2003/0168679 décrit un capteur d'images comprenant deux microlentilles qui convergent ensemble la lumière au niveau de la zone photosensible. Le document JP11040787 décrit un capteur d'images comprenant des microlentilles qui permettent aussi une couvergence améliorée.

### Résumé de l'invention

La présente invention vise à proposer un capteur d'image constitué d'une matrice de cellules photosensibles permettant de focaliser, pour chaque cellule photosensible, davantage de lumière sur la zone photosensible de la cellule photosensible que ne le permet le capteur d'image décrit dans l'état de l'art.

Un autre objet de la présente invention est de pallier la perte de sensibilité périphérique d'un capteur d'image.

Pour atteindre ces objets, la présente invention prévoit une structure de pixel de capteur d'image comprenant une zone photosensible, un empilement de couches d'isolement recouvrant la zone photosensible, et un dispositif de focalisation de la lumière du pixel vers la zone photosensible. Le dispositif de focalisation comprend des première et seconde microlentilles, la première microlentille étant disposée entre des couches de l'empilement et conjuguant la seconde microlentille avec la zone photosensible.

Selon un mode de réalisation de la présente invention, le capteur comprend une face d'exposition à la lumière et la deuxième microlentille est située sur la face d'exposition.

Selon un mode de réalisation de la présente invention, la première microlentille est constituée d'un premier matériau ayant un premier indice de réfraction, les couches de l'empilement adjacentes à la première microlentille étant constituées d'un second matériau ayant un second indice de réfraction inférieur au premier indice de réfraction.

Selon un mode de réalisation de la présente invention, la première microlentille est à base de nitrure de silicium entre deux couches d'oxyde de silicium.

Selon un mode de réalisation de la présente invention, la première microlentille est disposée sensiblement au tiers de la distance entre la deuxième microlentille et la zone photosensible.

L'invention vise aussi un capteur d'image comportant un ensemble de structures de pixels tels que ci-dessus.

Selon un mode de réalisation de la présente invention, l'axe optique de la première microlentille et l'axe optique de la seconde microlentille d'au moins une structure de pixel de l'ensemble de la structure de pixels sont parallèles et décalés.

Selon un mode de réalisation de la présente invention, le décalage entre l'axe optique de la première microlentille et l'axe optique de la seconde microlentille augmente lorsque l'on s'éloigne du centre du capteur d'image.

L'invention vise aussi un procédé de fabrication d'un capteur d'image, comprenant les étapes consistant à former une zone photosensible au niveau d'un substrat ; former un premier empilement de couches d'isolement ; former pour la zone photosensible une première microlentille ; former un second empilement de couches d'isolement ; et former pour la zone photosensible une seconde microlentille de sorte que pour la zone photosensible, la première microlentille correspondante conjugue la seconde microlentille correspondante avec ladite zone photosensible.

Selon un mode de réalisation de la présente invention, l'étape de formation de la première microlentille comprend les étapes suivantes : déposer une couche à base de nitrure de silicium ; déposer une couche de résine sur le premier empilement ; former à l'aplomb de chaque position souhaitée d'une première microlentille un bloc de résine ayant la forme souhaitée de la première microlentille ; et graver le bloc de résine et la couche à base de nitrure de silicium pour former la première microlentille dans la couche à base de nitrure de silicium, la première microlentille ayant la forme du bloc de résine associé.

### Brève description des dessins

Ces objets, caractéristiques et avantages, ainsi que d'autres de la présente invention seront exposés en détail dans la description suivante d'exemples de réalisation particuliers faite à titre non-limitatif en relation avec les figures jointes parmi lesquelles :
la figure 1, précédemment décrite, est une vue en perspective schématique d'un capteur d'image ;
la figure 2, précédemment décrite, est une vue en coupe schématique d'une cellule photosensible d'un capteur d'image ;
la figure 3, précédemment décrite, est une vue en coupe schématique d'une cellule photosensible située en bord de matrice de pixels ;
la figure 4 est une vue en coupe schématique d'une cellule photosensible d'un capteur d'image selon la présente invention ;
la figure 5 est une vue en coupe schématique d'une cellule photosensible selon la présente invention située en bord de matrice de pixels ; et
les figures 6A, 6B et 6C illustrent des étapes successives d'un procédé de réalisation d'une cellule selon l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

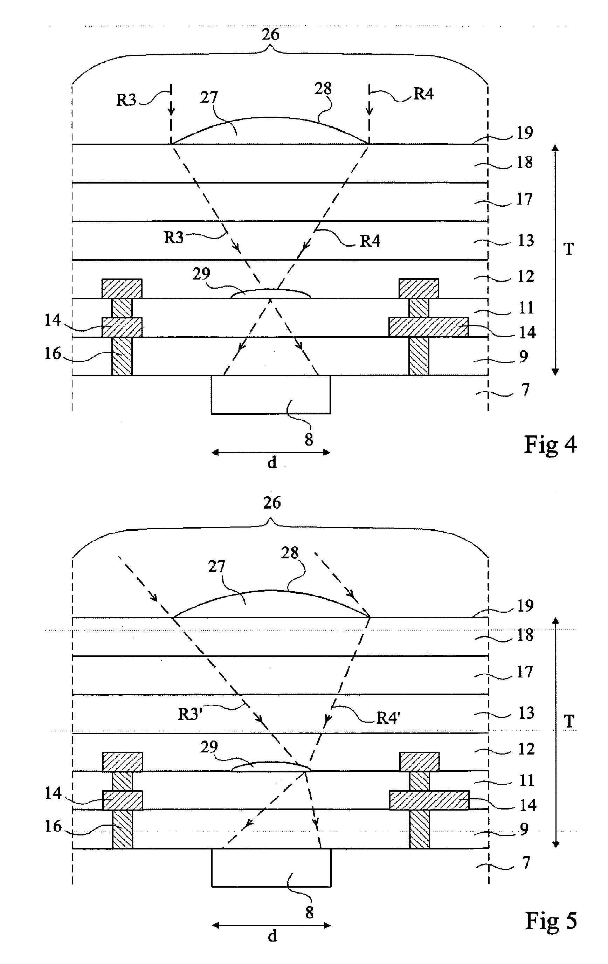

La figure 4 est une vue en coupe d'un exemple de réalisation d'une cellule photosensible 26 d'un capteur d'image. La cellule 26 a sensiblement la même structure que la cellule 6 de la figure 2. Toutefois, entre les couches d'isolement 11, 12 de l'empilement de couches d'isolement 9, 11, 12, 13, la cellule photosensible 26 comprend une microlentille 29. Une couche d'égalisation 18 planarisée recouvre l'élément de filtre 17, la face supérieure de la couche 18 constitue la face d'exposition 19 exposée à la lumière sur laquelle est disposée une microlentille 27. La focale de la microlentille 29 est choisie pour que la microlentille 29 forme l'image de la microlentille 27 sur la zone photosensible 8 associée. En d'autres termes, la microlentille 29 conjugue le plan de la microlentille 27 et celui de la zone photosensible 8 associée, avec un grandissement inférieur ou égal au rapport entre la taille d de la zone photosensible et la taille de la cellule photosensible 26 (ou de la microlentille 27). On a ainsi formé un dispositif de focalisation permettant de focaliser la lumière vers la zone photosensible 8. L'axe optique de la microlentille 29 est sensiblement confondu avec celui de la microlentille 27. Les rayons R3 et R4 représentés à titre d'exemple convergent sur la microlentille 29, contrairement aux rayons R1 et R2 qui, eux, convergeaient directement sur la zone photosensible 8. Pour une même distance T entre la microlentille et la zone photosensible, la microlentille 27 est donc plus convergente que la microlentille 21. La surface extérieure 28 de la microlentille 27 est plus bombée et donc plus facile à élaborer par le procédé de fabrication standard de fluage.

Un premier avantage de la présente invention réside donc dans la mise en oeuvre d'un procédé de réalisation de la microlentille 27 plus simple, plus fiable et donc plus répétable.

La figure 5 est une vue en coupe d'une cellule photosensible 26 située en bord de matrice de pixels. Des rayons lumineux R3' et R4' ont été représentés à titre d'exemple. La microlentille 29 conjuguant la microlentille 27 avec la zone photosensible 8, les rayons R3' et R4' convergent sur la microlentille 29. L'image est alors reconstituée sur la zone photosensible 8 sans perte d'intensité lumineuse ni de résolution bien que la structure de pixel se trouve en bord de matrice.

Un deuxième avantage de la présente invention est donc une amélioration de la sensibilité périphérique lors de la restitution de l'image sur la zone photosensible 8 résultant d'un recentrage automatique de l'image d'une zone périphérique.

Dans un cas extrême dans lequel il faudrait décaler l'axe optique de la microlentille 29 par rapport à l'axe optique de la microlentille 27, afin d'assurer la formation de l'image sur la zone photosensible 8, on aura simplement à déplacer la microlentille 29. On aura ainsi effectué un rattrapage bien moins coûteux qu'une nouvelle disposition des structures de pixels qui nécessiterait l'utilisation d'un nouveau jeu de masques.

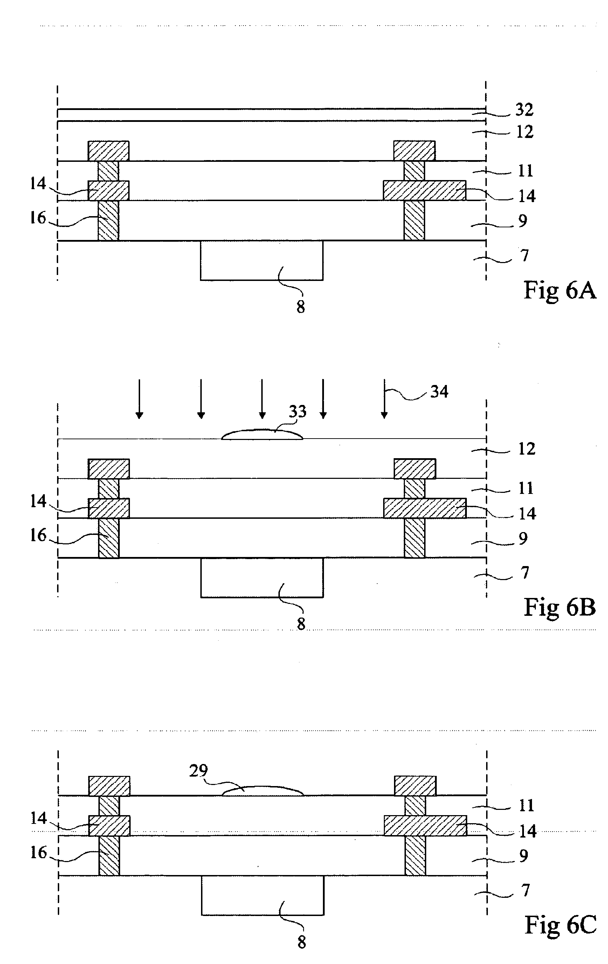

Les figures 6A, 6B et 6C représentent une cellule photosensible selon l'invention à différentes étapes d'un exemple de procédé de fabrication d'un capteur d'image selon l'invention.

La figure 6A illustre le résultat de premières étapes de fabrication d'une structure de pixels. Dans le cas où le substrat 7 est constitué de silicium dopé de type N, les zones photosensibles 8 sont formées par implantation ionique de dopants de type P. On dépose ensuite une couche d'isolement 9 dans laquelle on forme des vias conducteurs 16. Par la suite, on fabrique des pistes conductrices 14 avant de déposer une deuxième couche d'isolement 11. On procède de même que précédemment pour l'élaboration des vias conducteurs 16 et des pistes conductrices 14 associés à la couche d'isolement 11 avant de redéposer une couche d'isolement 12. La couche d'isolement 12 est par exemple en nitrure de silicium tandis que la couche d'isolement 11 est par exemple en oxyde de silicium. On dépose alors une couche de résine 32.

La figure 6B illustre une structure bombée 33 obtenue après gravure de la couche de résine 32 et fluage des blocs de résine gravés. L'étape suivante est une étape de gravure uniforme dans le sens des flèches 34. La structure bombée 33 en résine et la couche d'isolement 12 sont gravées de manière uniforme et sélective par rapport à la couche d'isolement 9 et aux pistes conductrices 14 par gravure plasma. La forme de la structure bombée 33 se reproduit au niveau de la couche 11. Une telle étape est appelée transfert de forme.

La figure 6C représente la structure obtenue à la fin de l'étape de transfert de forme qui aboutit à la forme de la microlentille 29.

Bien entendu, la présente invention est susceptible de diverses variantes et modifications qui apparaîtront à l'homme de l'art. En particulier, les dispositifs présentées dans les exemples de réalisation l'ont été pour des dispositifs comportant deux niveaux de pistes conductrices 14 et deux niveaux de vias conducteurs 16. On pourra réaliser ces dispositifs avec un nombre de niveaux de pistes conductrices 14 et de niveaux de vias conducteurs 16 inférieur ou supérieur. La position de la microlentille 29 pourra varier et donc ne pas se trouver forcément au-dessus du deuxième niveau de vias conducteurs 16. En effet la microlentille 29 pourra être réalisée dans un niveau inférieur ou supérieur. La microlentille 29 pourra être à base de nitrure de silicium et être en un composé de type SiNO.

## Revendications

1. Structure de pixel de capteur d'image comprenant :
une zone photosensible (8),
un empilement de couches d'isolement (9, 11, 12, 13) recouvrant la zone photosensible (8), et
un dispositif de focalisation de la lumière du pixel vers la zone photosensible (8), comprenant des première (29) et seconde microlentilles (27), la première microlentille (29) étant disposée entre des couches de l'empilement (9, 11, 12, 13) **caractérisée en ce que** la première microlentille (29) conjugue la seconde microlentille (27) avec la zone photosensible (8).

2. Structure de pixel selon la revendication 1, dans laquelle le capteur comprend une face d'exposition (19) à la lumière et dans lequel la deuxième microlentille (27) est située sur la face d'exposition (19).

3. Structure de pixel selon la revendication 1, dans laquelle la première microlentille (29) est constituée d'un premier matériau ayant un premier indice de réfraction, les couches de l'empilement adjacentes (11, 13) à la première microlentille (29) étant constituées d'un second matériau ayant un second indice de réfraction inférieur au premier indice de réfraction.

4. Structure de pixel selon la revendication 3, dans laquelle la première microlentille (29) est à base de nitrure de silicium entre deux couches d'oxyde de silicium.

5. Structure de pixel selon la revendication 1, dans laquelle la première microlentille (29) est disposée sensiblement au tiers de la distance entre la deuxième microlentille (27) et la zone photosensible (8).

6. Capteur d'image comportant un ensemble de structures de pixels selon la revendication 1.

7. Capteur d'image selon la revendication 6, dans lequel l'axe optique de la première microlentille (29) et l'axe optique de la seconde microlentille (27) d'au moins une structure de pixel de l'ensemble de la structure de pixels, sont parallèles et décalés.

8. Capteur d'image selon la revendication 7, dans lequel le décalage entre l'axe optique de la première microlentille (29) et l'axe optique de la seconde microlentille (27) augmente lorsque l'on s'éloigne du centre du capteur d'image.

9. Procédé de fabrication d'un capteur d'image, comprenant les étapes suivantes :
former une zone photosensible (8) au niveau d'un substrat (7) ;
former un premier empilement de couches d'isolement (9, 11);
former pour la zone photosensible (8) une première microlentille (29) ;
former un second empilement de couches d'isolement (12, 13) ; et **caractérisée par** l'étage suivante:
former pour la zone photosensible (8) une seconde microlentille (27) de sorte que pour la zone photosensible (8), la première microlentille (29) correspondante conjugue la seconde microlentille (27) correspondante avec ladite zone photosensible (8).

10. Procédé selon la revendication 9, dans lequel l'étape de formation de la première microlentille (29) comprend les étapes suivantes :
déposer une couche à base de nitrure de silicium ;
déposer une couche de résine sur le premier empilement (9, 11) ;
former à l'aplomb de chaque position souhaitée d'une première microlentille (29) un bloc de résine ayant la forme souhaitée de la première microlentille (29) ; et
graver le bloc de résine et la couche à base de nitrure de silicium pour former la première microlentille (29) dans la couche à base de nitrure de silicium, la première microlentille (29) ayant la forme du bloc de résine associé.

## Claims

1. An image sensor pixel structure comprising:
a photosensitive area (8),
a stacking of insulating layers (9, 11, 12, 13) covering the photosensitive area (8), and
a device for focusing the pixel light on the photosensitive area (8), comprising first (29) and second (27) microlenses, the first microlens (29) being arranged between layers of the stacking (9, 11, 12, 13),
**characterized in that** the first microlens (29) conjugates the second microlens (27) with the photosensitive area (8).

2. The pixel structure of claim 1, wherein the sensor comprises a surface (19) of exposition to light and wherein the second microlens (27) is located on the exposition surface (19).

3. The pixel structure of claim 1, wherein the first microlens (29) is made of a first material having a first refraction index, the layers of the stacking (11, 13) adjacent to the first microlens (29) being made of a second material having a second refraction index smaller than the first refraction index.

4. The pixel structure of claim 3, wherein the first microlens (29) comprises silicon nitride between two silicon oxide layers.

5. The pixel structure of claim 1, wherein the first microlens (29) is substantially arranged at one third of the distance between the second microlens (27) and the photosensitive area (8).

6. An image sensor comprising an assembly of the pixel structures of claim 1.

7. The image sensor of claim 6, wherein the optical axis of the first microlens (29) and the optical axis of the second microlens (27) of at least one pixel structure of the pixel structure assembly are parallel and offset.

8. The image sensor of claim 7, wherein the offset between the optical axis of the first microlens (29) and the optical axis of the second microlens (27) increases as it is moved away from the center of the image sensor.

9. A method for manufacturing an image sensor, comprising the steps of:
forming a photosensitive area (8) at the level of a substrate (7);
forming a first stacking of insulating layers (9, 11);
forming for each photosensitive area (8) a first microlens (29);
forming a second stacking of insulating layers (12, 13); and **characterized by** the following steps:
forming for each photosensitive area (8) a second microlens (27) so that the first corresponding microlens (29) conjugates the second corresponding microlens (27) with said photosensitive area (8).

10. The method of claim 9, wherein the step of forming the first microlens (29) comprises the steps of:
depositing a layer comprising silicon nitride;
depositing a resin layer on the first stacking (9, 11);
forming straight above each desired position of a first microlens (29) a resin block having the desired shape of the first microlens (29); and
etching the resin block and the silicon nitride based layer to form the first microlens (29) in the silicon nitride based layer, the first microlens (29) having the shape of the associated resin block.

## Patentansprüche

1. Bildsensorpixelstruktur, die folgendes aufweist:
einen fotosensitiven bzw. lichtempfindlichen Bereich (8),
einen Stapel von isolierenden Schichten (9, 11, 12, 13), die den lichtempfindlichen Bereich (8) bedecken, und
eine Vorrichtung zum Fokussieren des Pixellichtes auf dem lichtempfindlichen Bereich (8), die erste (29) und zweite (27) Mikrolinsen aufweist, wobei die erste Mikrolinse (29) zwischen Schichten des Stapels (9, 11, 12, 13) angeordnet ist,
**dadurch gekennzeichnet, dass** die erste Mikrolinse (29) die zweite Mikrolinse (27) mit dem lichtempfindlichen Bereich (8) konjugiert bzw. zusammenführt.

2. Pixelstruktur nach Anspruch 1, wobei der Sensor eine Belichtungsoberfläche (19) aufweist, und wobei die zweite Mikrolinse (27) auf der Belichtungsoberfläche (19) gelegen ist.

3. Pixelstruktur nach Anspruch 1, wobei die erste Mikrolinse (29) aus einem ersten Material mit einem ersten Brechungsindex gemacht ist, wobei die Schichten des Stapels (11, 13) benachbart zur ersten Mikrolinse (29) aus einem zweiten Material mit einem zweiten Brechungsindex gemacht sind, der kleiner ist als der erste Brechungsindex.

4. Pixelstruktur nach Anspruch 3, wobei die erste Mikrolinse (29) Siliziumnitrit zwischen zwei Siliziumoxydschichten aufweist.

5. Pixelstruktur nach Anspruch 1, wobei die erste Mikrolinse (29) im Wesentlichen bei einem Drittel der Distanz zwischen der zweiten Mikrolinse (27) und dem lichtempfindlichen Bereich (8) angeordnet ist.

6. Bildsensor, der eine Anordnung von Pixelstrukturen nach Anspruch 1 aufweist.

7. Bildsensor nach Anspruch 6, wobei die optische Achse der ersten Mikrolinse (29) und die optische Achse der zweiten Mikrolinse (27) von mindestens einer Pixelstruktur der Pixelstrukturanordnung parallel und versetzt sind.

8. Bildsensor nach Anspruch 7, wobei die Versetzung zwischen der optischen Achse der ersten Mikrolinse (29) und der optischen Achse der zweiten Mikrolinse (27) zunimmt, wenn sie weg von der Mitte des Bildsensors bewegt wird.

9. Verfahren zur Herstellung eines Bildsensors, welches folgende Schritte aufweist:
Bilden eines lichtempfindlichen Bereiches (8) auf dem Niveau eines Substrates (7);
Formen eines ersten Stapels von isolierenden Schichten (9, 11);
Formen einer ersten Mikrolinse (29) für jeden lichtempfindlichen Bereich (8);
Formen eines zweiten Stapels von isolierenden Schichten (12, 13); und
wobei das Verfahren durch die folgenden Schritte **gekennzeichnet** ist:
Formen einer zweiten Mikrolinse (27) für jeden lichtempfindlichen Bereich (8), so dass die erste entsprechende Mikrolinse (29) die zweite entsprechende Mikrolinse (27) mit dem lichtempfindlichen Bereich (8) konjugiert bzw. zusammenführt.

10. Verfahren nach Anspruch 9, wobei der Schritt des Formens der ersten Mikrolinse (29) folgende Schritte aufweist:
Ablagern einer Schicht, die Siliziumnitrit aufweist;
Ablagern einer Harzschicht auf dem ersten Stapel (9, 11);
Formen eines Harzblockes über jeder erwünschten Position einer ersten Mikrolinse (29) mit der erwünschten Form der ersten Mikrolinse (29); und
Ätzen des Harzblockes und der siliziumnitritbasierten Schicht, um die erste Mikrolinse (29) in der siliziumnitritbasierten Schicht zu formen,
wobei die erste Mikrolinse (29) die Form des assoziierten Harzblockes hat.
